(19) **Europäisches Patentamt / European Patent Office / Office européen des brevets**

(11) **EP 3 674 258 B1**

(12) # EUROPEAN PATENT SPECIFICATION

(45) Date of publication and mention
of the grant of the patent:
**03.04.2024 Bulletin 2024/14**

(21) Application number: **19210904.9**

(22) Date of filing: **22.11.2019**

(51) International Patent Classification (IPC):
**G01B 7/16** *(2006.01)*    **H03H 9/02** *(2006.01)*
**H04R 1/24** *(2006.01)*    **H04R 17/02** *(2006.01)*
**H04R 17/10** *(2006.01)*   **H04R 19/00** *(2006.01)*
**H10N 30/30** *(2023.01)*   **B81B 3/00** *(2006.01)*
**G01L 1/10** *(2006.01)*    **G01L 1/16** *(2006.01)*
**G01L 1/18** *(2006.01)*    **H03H 9/24** *(2006.01)*
**G01L 9/00** *(2006.01)*    **H04R 19/04** *(2006.01)*

(52) Cooperative Patent Classification (CPC):
**G01L 1/10; G01B 7/18; G01B 7/22; G01L 1/162;
G01L 1/183; G01L 9/0019; G01L 9/0022;
H03H 9/2457; H03H 9/2463; H04R 17/10;
H10N 30/306;** H03H 2009/02511; H04R 1/245;
H04R 17/02; H04R 19/005;                    (Cont.)

(54) **RESONATOR AND METHOD OF MANUFACTURING THE RESONATOR, AND STRAIN SENSOR AND SENSOR ARRAY INCLUDING THE RESONATOR**

RESONATOR UND VERFAHREN ZUR HERSTELLUNG EINES RESONATORS SOWIE DEHNUNGSSENSOR UND SENSORANORDNUNG MIT DEM RESONATOR

RÉSONATEUR, SON PROCÉDÉ DE FABRICATION, CAPTEUR DE CONTRAINTE ET RÉSEAU DE CAPTEURS COMPRENANT LE RÉSONATEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.12.2018 KR 20180173084**

(43) Date of publication of application:
**01.07.2020 Bulletin 2020/27**

(73) Proprietor: **Samsung Electronics Co., Ltd.
Gyeonggi-do 16677 (KR)**

(72) Inventors:
• **KIM, Cheheung
  16678, Gyeonggi-do, (KR)**
• **KANG, Sungchan
  16678, Gyeonggi-do, (KR)**
• **RHEE, Choongho
  16678, Gyeonggi-do, (KR)**
• **YOON, Yongseop
  16678, Gyeonggi-do, (KR)**
• **HONG, Hyeokki
  16678, Gyeonggi-do, (KR)**

(74) Representative: **Elkington and Fife LLP
Prospect House
8 Pembroke Road
Sevenoaks, Kent TN13 1XR (GB)**

(56) References cited:
EP-A1- 3 279 622        US-A1- 2011 266 919
US-A1- 2012 038 431     US-A1- 2014 202 260
US-A1- 2016 050 506     US-A1- 2017 119 350
US-A1- 2017 119 351     US-A1- 2017 143 308
US-B1- 9 090 451

• HOPCROFT M A ET AL: "What is the Young's
Modulus of Silicon?", JOURNAL OF
MICROELECTROMECHANICAL SYSTEMS, IEEE
SERVICE CENTER, US, vol. 19, no. 2, 2 April 2010
(2010-04-02), pages 229-238, XP011304787, ISSN:
1057-7157

(52) Cooperative Patent Classification (CPC): (Cont.)
H04R 19/04; H04R 2201/003

## Description

FIELD OF THE INVENTION

The disclosure relates to a resonator, a method of manufacturing the resonator, and a strain sensor and a sensor array including the resonator.

BACKGROUND OF THE INVENTION

Resonators are devices that oscillate in a certain frequency band. Resonators may be manufactured by forming a micro-oscillation structure on a semiconductor substrate, such as a silicon substrate, by using a micro-electro mechanical system (MEMS). Resonators are applicable to, for example, oscillation sensors such as mechanical filters and acoustic sensors. Oscillation sensors can be utilized as, for example, sensors that are mounted on mobile phones, home appliances, image display devices, virtual reality devices, augmented reality devices, and artificial intelligence (AI) speakers, and can recognize oscillation that is generated by an external input, such as an external stress, an external pressure, or an external force.

Document US 2017/119351 A1 discloses a piezoelectric element comprising a vibrating plate including single crystal silicon having anisotropy having orientation with a relatively high Young's modulus and orientation with a relatively low Young's modulus as a vibrating material.

Document US 2017/143308 A1 discloses a piezoelectric element comprising a vibrating plate having [111]-oriented single crystal silicon as a vibrating material.

Document US 2017/119350 A1 discloses a piezoelectric element comprising a vibrating plate including single crystal silicon having anisotropy having orientation with a relatively high Poisson's ratio and orientation with a relatively low Poisson's ratio as a vibrating material.

Document US 2011/0266919 A1 discloses a detection sensor including plural beam-like resonators. The resonators are formed on the inside of a cavity, which is formed in a substrate made of a silicon material, more specifically, polysilicon or single crystal silicon, by processing the substrate using a MEMS technique such as a photolithography method. The resonators have a rectangular shape in plan view and are made of the silicon material, whereby single crystal silicon may constitute the substrate.

Document US 9090451 B1 discloses a resonator include a resonator body suspended over a substrate, the resonator body including monocrystalline silicon.

Document Hopcroft M A et al: "What is the Young's Modulus of Silicon?", JOURNAL OF MICROELECTROMECHANICAL SYSTEMS, IEEE SERVICE CENTER, US, vol. 19, no. 2, 1 April 2010, pages 229-238, XP011304787 discloses a summary of the elastic behavior of silicon as an anisotropic crystalline material.

SUMMARY OF THE INVENTION

The invention is defined by the appended claims. Claim 1 defines a sensor array comprising a plurality of resonators. Claim 7 defines a method of manufacturing a sensor array comprising a plurality of resonators.

Provided are a resonator, a method of manufacturing the resonator, and a strain sensor and a sensor array including the resonator

Additional aspects will be set forth in part in the description which follows and, in part, will be apparent from the description, or may be learned by practice of the presented embodiments.

According to an aspect of the disclosure, there is provided a resonator that extends in a lengthwise direction from a support, the resonator comprising: a single crystal material, wherein the resonator extends in a crystal orientation determined based on at least one a from among a Young's modulus and a Poisson's ratio, the crystal orientation being from among a plurality of crystal orientations of the single crystal material.

By way of example, embodiments may provide a high Q mechanical resonator using crystal orientation.

Proposed concepts may relate to a mechanical filter of a micro-electro mechanical system (MEMS) structure and a resonator type micro-fabricated semiconductor device. In particular, embodiments may be directed to improving sensitivity and frequency band selectivity of a measurement signal by having a high signal output and a Q-factor with respect to an external input signal (inertial force, pressure, etc.).

Embodiments may be configured to have a smaller effective modulus when the strain occurs. In this way, the portion of a sensing layer among all the stress generated in the entire composite layer may be increased. An output of the sensor structure may therefore be improved or even maximized.

Embodiments may provide a strain / stress sensor structure using a single crystal substrate. The manufacture of such a structure may comprise: forming a double-layered structure including a part of a single crystal substrate and a sensing layer formed thereon, and adjusting a direction (angle) of a pattern to satisfy a required effective modulus using a Young's modulus and Poisson ratio according to crystal orientation (a miller index) of the single crystal substrate.

The resonator may extend in the crystal orientation having a smallest Young's modulus.

The resonator may extend in the crystal orientation having a largest Poisson's ratio.

The resonator may be a beam shape extending in the lengthwise direction.

One end of the resonator may be fixed to the support.

Two ends of the resonator may be fixed to the support.

The support may comprise the single crystal material.

According to another aspect of the disclosure, there is provided a resonator that extends in a lengthwise direction from a support, the resonator comprising: a single crystal silicon having a (100) crystal plane, wherein the resonator extends in a crystal orientation determined based on at least one from among a Young's modulus and a Poisson's ratio, the crystal orientation being from among crystal orientations of the single crystal silicon.

The resonator may extend in the crystal orientation having a smallest Young's modulus and a largest Poisson's ratio.

The resonator may extend in a <100> crystal orientation of the single crystal silicon. The <100> crystal orientation may provide a structure which has a large Q-factor with the largest output and a narrow band width.

The resonator may extend in the crystal orientation between a <100> crystal orientation and a <110> crystal orientation of the single crystal silicon.

The resonator may be a beam shape extending in the lengthwise direction.

At least one end of the resonator may be fixed to the support.

The support may comprise the single crystal silicon.

According to another aspect of the disclosure, there is provided a method of manufacturing a resonator comprising: patterning a substrate including a single crystal material to form a portion of the substrate to extend in a crystal orientation determined based on at least one from among a Young's modulus and a Poisson's ratio, the crystal orientation being from among crystal orientations of the single crystal material.

The patterning the substrate may further comprise: patterning the substrate to extend the portion of the substrate in a crystal orientation having a smallest Young's modulus.

The patterning the substrate may further comprise: patterning the substrate to extend the portion of the substrate in a crystal orientation having a largest Poisson's ratio.

The substrate may include single crystal silicon having a (100) crystal plane, and the patterning the substrate may further comprise: patterning the substrate to extend the portion of the substrate in a <100> crystal orientation of the single crystal silicon.

According to another aspect of the disclosure, there is provided a strain sensor comprising: a resonator provided to extend in a lengthwise direction from a support; and a sensing device configured to measure a strain of the resonator, wherein the resonator comprises a single crystal material and extends in a crystal orientation determined based on at least one from among a Young's modulus and a Poisson's ratio, the crystal orientation being from among crystal orientations of the single crystal material.

The resonator may extend in the crystal orientation having a smallest Young's modulus.

The resonator may extend in the crystal orientation having a largest Poisson's ratio.

The resonator may comprise a single crystal silicon having a (100) crystal plane.

The resonator may extend in a <100> crystal orientation of the single crystal silicon.

The resonator may extend in the crystal orientation between a <100> crystal orientation and a <110> crystal orientation of the single crystal silicon.

At least one end of the resonator may be fixed to the support.

The sensing device may comprise a piezoelectric device, a piezoresistive device, or a capacitive device.

The sensing device may comprise an optical device that measures an angle variation of light that is reflected by the resonator.

According to the invention, there is provided a sensor array comprising: a plurality of resonators, each of the plurality of resonators extending in a lengthwise direction from a support and having different resonance frequencies and different dimensions; and a plurality of sensing devices configured to measure strains of the plurality of resonators, wherein each of the plurality of resonators comprises a single crystal material and extends in a crystal orientation determined based on at least one from among a Young's modulus and a Poisson's ratio, the crystal orientation being from among crystal orientations of the single crystal material.

Each of the plurality of resonators extend in a crystal orientation having a smallest Young's modulus.

Each of the plurality of resonators extend in a crystal orientation having a largest Poisson's ratio.

Each of the plurality of resonators comprise a single crystal silicon having a (100) crystal plane.

Each of the plurality of resonators extend in a <100> crystal orientation of the single crystal silicon.

In an example not forming part of the current invention, each of the plurality of resonators may extend in a crystal orientation between a <100> crystal orientation and a <110> crystal orientation of the single crystal silicon.

At least one end of each of the plurality of resonators is fixed to the support.

The support comprises the single crystal material

According to another aspect of the disclosure, there is provided a resonator comprising: a support portion formed of a single crystal material; a resonating portion formed of the single crystal material and extending from the support portion, wherein the resonating portion is formed at an inclined angle with respect to a (100) crystal plane of the single crystal material based on at least one from among a Young's modulus and a Poisson's ratio.

The support portion may be an etched portion of the single crystal material. The resonating portion may be an etched portion of the single crystal material.

The inclined angle may be between a <100> crystal orientation and a <110> crystal orientation of the single crystal material.

The inclined angle may be <100> crystal orientation of the single crystal material.

According to another aspect of the disclosure, there is provided a method of manufacturing a resonator comprising: providing a reference line pattern parallel to a flat zone of a single crystal material wafer on a photomask; patterning a resonating portion on the single crystal material wafer based on the photomask, wherein the resonating portion is patterned at an inclined angle with respect to the reference line pattern based on at least one from among a Young's modulus and a Poisson's ratio.

Embodiments may therefore provide a method of manufacturing a high Q mechanical resonator, and such a method may use crystal orientation.

The patterning the resonating portion may comprise: etching a thin pattern having a shape of fan ribs on a surface of the single crystal material wafer; selecting a direction in which the thin pattern does not collapse; and aligning the direction and the reference line of the photomask with each other.

The patterning maybe by using a wet etch solution.

The flat zone may be a (100) crystal plane of the single crystal material.

BRIEF DESCRIPTION OF THE DRAWINGS

These and/or other aspects will become apparent and more readily appreciated from the following description of the embodiments, taken in conjunction with the accompanying drawings in which:

FIG. 1A illustrates a Young's modulus according to crystal orientations of single crystal silicon having a (100) crystal plane;

FIG. 1B illustrates a Poisson's ratio according to crystal orientations of single crystal silicon having a (100) crystal plane;

FIG. 2 illustrates general resonators manufactured by patterning a single crystal silicon wafer having the (100) crystal plane;

FIGS. 3A and 3B are respectively a plan view and a cross-sectional view illustrating a general resonator;

FIG. 4 illustrates a strain sensor using the general resonator of FIGS. 3A and 3B.

FIG. 5 illustrates resonators according to an exemplary embodiment manufactured by patterning a single crystal silicon wafer having the (100) crystal plane;

FIGS. 6A and 6B are respectively a plan view and a cross-sectional view illustrating a resonator according to an exemplary embodiment;

FIG. 7 illustrates a strain sensor using a resonator according to an exemplary embodiment;

FIGS. 8 through 11 illustrate sensing devices applying the strain sensor of FIG. 7;

FIG. 12A illustrates a state after an end of a strain sensor using a general resonator is displaced upwards by an external input;

FIG. 12B illustrates a state after an end of a strain sensor using a resonator according to an exemplary embodiment is displaced upwards by an external input;

FIG. 13A illustrates a state after an end of a strain sensor using a general resonator is displaced downwards;

FIG. 13B is a cross-sectional view taken along line I-I' of FIG. 13A;

FIG. 14A illustrates a state after an end of a strain sensor using a resonator according to an exemplary embodiment is displaced downwards;

FIG. 14B is a cross-sectional view taken along line I-I' of FIG. 14A;

FIG. 15A illustrates a state after an end of a strain sensor using a general resonator is displaced upwards;

FIG. 15B is a cross-sectional view taken along line II-II' of FIG. 15A;

FIG. 16A illustrates a state after an end of a strain sensor using a resonator according to an exemplary embodiment is displaced upwards;

FIG. 16B is a cross-sectional view taken along line II-II' of FIG. 16A;

FIG. 17A illustrates resonators manufactured by patterning a single crystal silicon wafer having a (100) crystal plane in a crystal orientation;

FIG. 17B illustrates resonance characteristics according to the crystal orientations of the resonators of FIG. 17A;

FIG. 18 illustrates a microphone according to another exemplary embodiment;

FIG. 19A illustrates resonance characteristics of a microphone using general resonators;

FIG. 19B illustrates resonance characteristics of a microphone using resonators according to an exemplary embodiment; and

FIG. 20 illustrates a resonator according to another exemplary embodiment.

DETAILED DESCRIPTION

Exemplary embodiments will now be described more fully with reference to the accompanying drawings. Like reference numerals in the drawings denote like elements, and, in the drawings, the sizes of elements may be exaggerated for clarity and for convenience of explanation. In this regard, the present embodiments may have different forms and should not be construed as being limited to the descriptions set forth herein.

It will be understood that when a layer is referred to as being "on" another layer or substrate, it can be directly on the other layer or substrate, or intervening layers may also be present. An expression used in the singular encompasses the expression of the plural, unless it has a clearly different meaning in the context. The terms "comprises" and/or "comprising" or "includes" and/or "including" when used in this specification, specify the presence of stated elements, but do not preclude the presence or addition of one or more other elements.

The use of the terms "a" and "an" and "the" and similar referents are to be construed to cover both the singular and the plural. The operations that constitute a method described herein can be performed in any suitable order unless otherwise indicated herein or otherwise clearly contradicted by context. The disclosure is not limited to the described order of the operations. The use of any and all examples, or exemplary language provided herein, is intended merely to better illuminate the embodiments of disclosure and does not pose a limitation on the scope of the disclosure unless otherwise claimed.

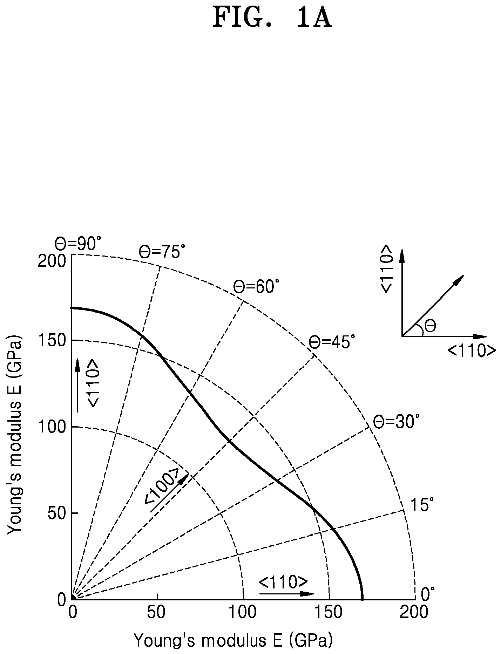

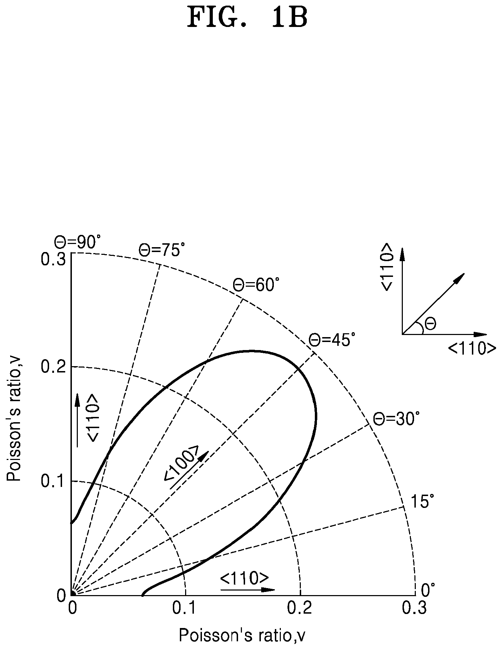

A crystal structure of single crystal silicon is a diamond structure, and thus, as shown in FIGS. 1A and 1B, the Young's modulus and the Poisson's ratio may vary according to crystal orientations of single crystal silicon. The Young's modulus means a degree to which a material resists an external pressure. The Poisson's ratio means a ratio between a lateral strain and a longitudinal strain when a vertical stress is applied to a material.

FIG. 1A illustrates a Young's modulus according to crystal orientations of single crystal silicon having a (100) crystal plane. FIG. 1B illustrates a Poisson's ratio according to the crystal orientations of the single crystal silicon having the (100) crystal plane. (100) indicates a Miller index that represents a crystal plane.

Referring to FIG. 1A, in the single crystal silicon having the (100) crystal plane, the Young's modulus in the <110> crystal orientation is largest and the Young's modulus in the <100> crystal orientation is smallest. <110> and <100> indicate Miller indexes that represent crystal orientations.

Referring to FIG. 1B, in the single crystal silicon having the (100) crystal plane, the Poisson's ratio in the <110> crystal orientation is smallest and the Poisson's ratio in the <100> crystal orientation is largest.

An effective Young's modulus may be expressed as in Equation (1) by using the Young's modulus and the Poisson's ratio.

$$E_{eff} = \frac{E}{1-v^2} \quad \ldots\ldots \text{ Equation (1)}$$

where $E_{eff}$ indicates the effective Young's modulus, E indicates the Young's modulus, and v indicates the Poisson's ratio.

According to Equation (1), the effective Young's modulus is proportional to the Young's modulus and is inversely proportional to the Poisson's ratio. Accordingly, in the single crystal silicon having the (100) crystal plane, the effective Young's modulus in the <110> crystal orientation is largest and the effective Young's modulus in the <100> crystal orientation is smallest. Therefore, in the single crystal silicon having the (100) crystal plane, a stiffest structure may be realized in the <110> crystal orientation, and a most flexible structure may be realized in the <100> crystal orientation.

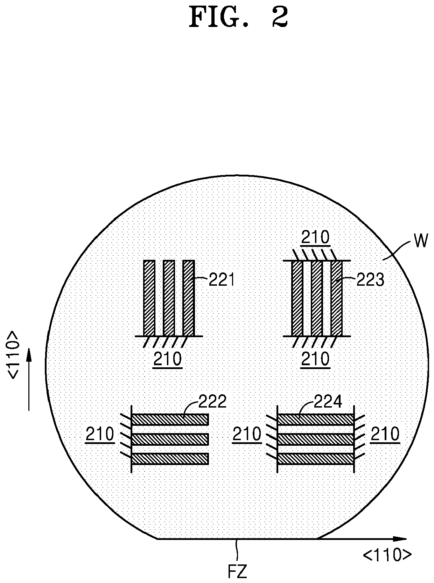

FIG. 2 illustrates general resonators manufactured by patterning a single crystal silicon wafer having the (100) crystal plane.

Referring to FIG. 2, a flat zone FZ, which serves as a base line when processing a single crystal silicon wafer W having the (100) crystal plane, is provided on one side of the single crystal silicon wafer W. The flat zone FZ is generally formed in a direction parallel to the <110> crystal orientation. In this case, a direction perpendicular to the flat zone FZ is the <110> crystal orientation.

FIG. 2 illustrates four types of general resonators 221, 222, 223, and 224, namely, first, second, third, and fourth resonators 221, 222, 223, and 224, manufactured by patterning the single crystal silicon wafer W having the (100) crystal plane. The first and second resonators 221 and 222 are manufactured to have a cantilever-type structure in which one end of a resonator is fixed to a support 210, and the third and fourth resonators 223 and 224 are manufactured to have a bridge-type structure in which both ends of a resonator are fixed to supports 210. The support 210 may include single crystal silicon having the (100) crystal plane, which is the same as a material included in the single crystal silicon wafer W.

The first and third resonators 221 and 223 are provided to extend in a <110> crystal orientation perpendicular to the flat zone FZ from the support 210. The second and fourth resonators 222 and 224 are provided to extend in a <110> crystal orientation parallel to the flat zone FZ from the support 210. As such, the general resonators 221, 222, 223, and 224 are provided to extend in the <110> crystal orientation of single crystal silicon having the (100) crystal plane.

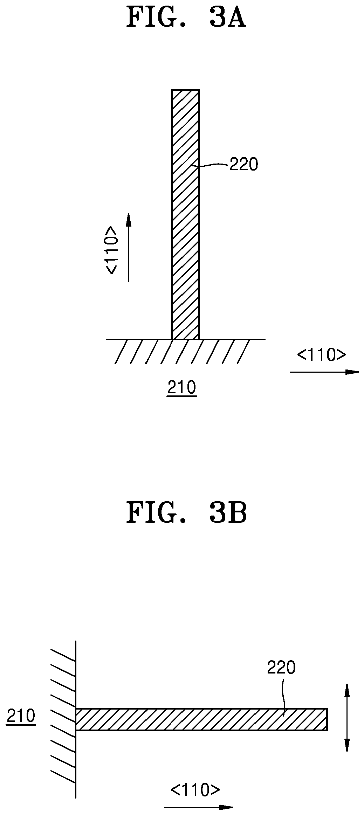

FIGS. 3A and 3B illustrate one of the general resonators 221, 222, 223, and 224 of FIG. 2. In detail, FIG. 3A is a plan view of a general resonator, and FIG. 3B is a cross-sectional view of the general resonator.

Referring to FIGS. 3A and 3B, a general resonator 220 is provided to extend from the support 210 in the <110> crystal orientation that is parallel to or perpendicular to the flat zone FZ. The general resonator 220 may be manufactured in a beam shape. One end of the general resonator 220 is fixed to the support 210, and the other end of the general resonator 220 is provided to vertically move according to an external input, for example, an external stress, an external pressure, or an external force.

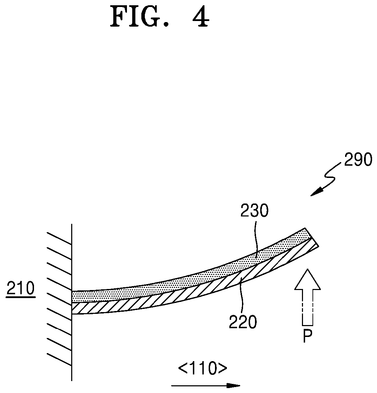

FIG. 4 illustrates a strain sensor using the resonator of FIGS. 3A and 3B.

Referring to FIG. 4, a strain sensor 290 includes the general resonator 220 and a sensing device 230 provided on the general resonator 220. As described above, the general resonator 220 includes single crystal silicon having the (100) crystal plane, and is provided to extend in the <110> crystal orientation from the support 210. The sensing device 230 may be provided on an upper surface of the general resonator 220. The sensing device 230 may measure a strain of the general resonator 220 that is generated by an extern input P.

As such, the general resonator 220 manufactured using single crystal silicon having the (100) crystal plane is provided to extend from the support 210 in the <110> crystal orientation that is parallel to or perpendicular to the flat zone FZ.

In the single crystal silicon having the (100) crystal plane, as described above, the Young's modulus E is largest in the <110> crystal orientation. Moreover, even when the Poisson's ratio v in the <110> crystal orientation is considered, the effective Young's modulus $E_{eff}$ has a largest value in the <110> crystal orientation according to Equation (1). Accordingly, the general resonator 220 provided to extend in the <110> crystal orientation has a stiff characteristic that generates a relatively small displacement compared with other crystal orientations. Thus, when the strain sensor 290 is manufactured using the general resonator 220, sensing efficiency may degrade.

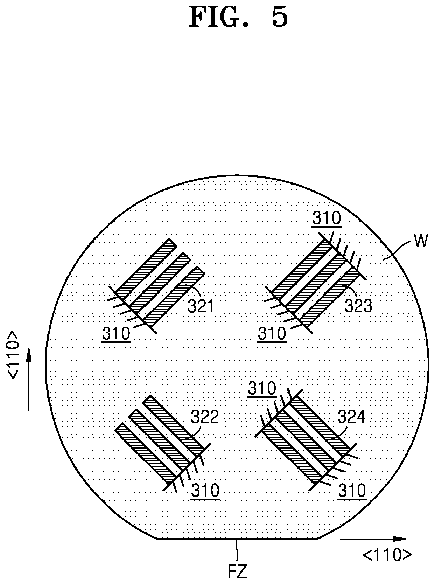

FIG. 5 illustrates resonators according to an exemplary embodiment manufactured by patterning a single crystal silicon wafer having the (100) crystal plane.

Referring to FIG. 5, a flat zone FZ, which serves as a base line when processing the single crystal silicon wafer W, is provided on one side of the single crystal silicon wafer W having the (100) crystal plane. The flat zone FZ is formed in a direction parallel to the <110> crystal orientation. In this case, a direction perpendicular to the flat zone FZ is the <110> crystal orientation.

FIG. 5 illustrates four types of first, second, third, and fourth resonators 321, 322, 323, and 324 according to an exemplary embodiment manufactured by patterning the single crystal silicon wafer W having the (100) crystal plane. The first and second resonators 321 and 322 are manufactured to have a cantilever-type structure in which one end of a resonator is fixed to a support 310, and the third and fourth resonators 323 and 324 are manufactured to have a bridge-type structure in which both ends of a resonator are fixed to supports 310. The support 310 may include single crystal silicon having the (100) crystal plane, which is the same as a material included in the single crystal silicon wafer W.

The first and third resonators 321 and 323 are provided to extend from the support 310 in the <100> crystal orientation that is 45° inclined with respect to the <110> crystal orientation (i.e., a direction parallel to the flat zone FZ). The second and fourth resonators 322 and 324 are provided to extend from the support 310 in the <100> crystal orientation that is 135° inclined with respect to the <110> crystal orientation. As such, the first, second, third, and fourth resonators 321, 322, 323, and 324 according to an exemplary embodiment are provided to extend in the <100> crystal orientation of single crystal silicon having the (100) crystal plane.

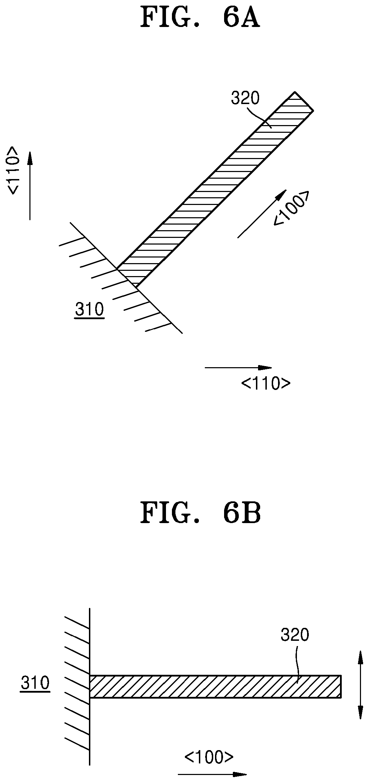

FIGS. 6A and 6B illustrate one of the first, second, third, and fourth resonators 321, 322, 323, and 324 according to an exemplary embodiment of FIG. 5. In detail, FIG. 6A is a plan view of a resonator according to an exemplary embodiment, and FIG. 6B is a cross-sectional view of the resonator according to an exemplary embodiment.

Referring to FIGS. 6A and 6B, a resonator 320 is provided to extend in the <100> crystal orientation from a support 310. The resonator 320 may be manufactured in a beam shape. One end of the resonator 320 is fixed to the support 310, and the other end of the resonator 320 is provided to vertically move according to an external input, for example, an external stress, an external pressure, or an external force.

According to an embodiment, the resonator may include a support portion 310 formed of a single crystal material and a resonating portion 320 formed of the signal crystal material and extending from the support portion. The resonating portion may formed at an inclined angle with respect to a (100) crystal plane of the single crystal material. The inclined angle is determined based on at least one from among a Young's modulus and a Poisson's ratio.

According to an embodiment, the method of manufacturing the resonator may include a series of semiconductor manufacturing process using a photomask. For instance, during the design of a photomask, a reference line pattern or shape aligned to a flat zone of the material wafer is provided on the photomask. The flat zone of a wafer represents the basic crystal orientation of the wafer. The direction of resonator patterns is designed as a relative angle to the reference line pattern. In this state, the relative angle is an angle at which the resonator is formed in a desired crystal orientation. Accordingly the resonator is patterned based on the photomask.

Next, a subsequent process is performed by being aligned to the previous photomask in the series of manufacturing processes.

According to an embodiment, to obtain a more precise angle, first, a thin pattern having a shape of fan ribs may be etched on the surface of the material wafer by using a wet etch solution such as KOH or TMAH. Next, an accurate direction (100) is determined by selecting a direction in which the pattern does not collapse, and the selected direction and the reference line of the photomask may be aligned to each other.

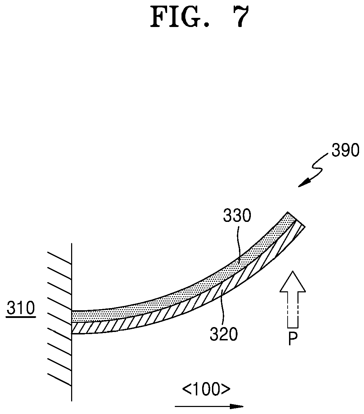

FIG. 7 illustrates a strain sensor 390 using the resonator 320 of FIGS. 6A and 6B.

Referring to FIG. 7, the strain sensor 390 includes the resonator 320, and a sensing device 330 provided on the resonator 320. As described above, the resonator 320 includes single crystal silicon having the (100) crystal plane, and is provided to extend in the <100> crystal orientation from the support 310. The sensing device 330 may be provided on an upper surface of the resonator 320. The sensing device 330 may measure a strain of the resonator 320 that is generated by an extern input P.

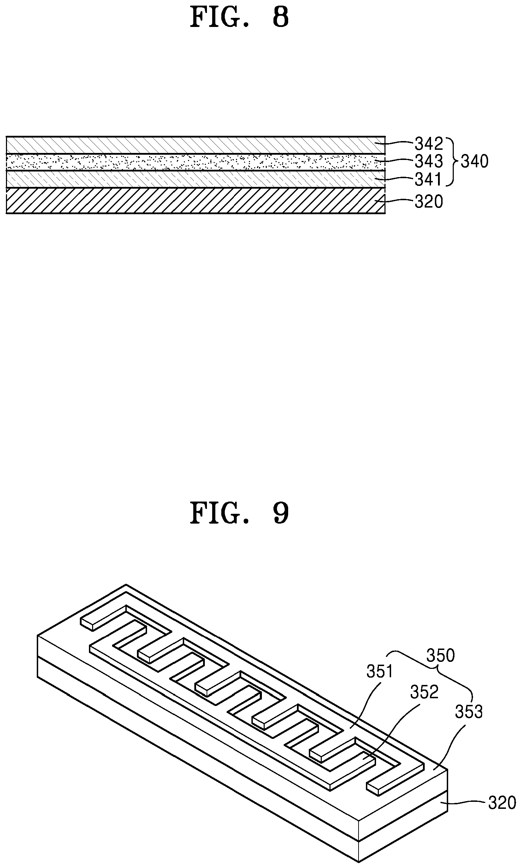

FIGS. 8 through 11 illustrate sensing devices applying the strain sensor 390 of FIG. 7.

FIG. 8 illustrates a case where a piezoelectric device is used as a sensing device. Referring to FIG. 8, a piezoelectric device 340 may include a piezoelectric layer 343 of which a voltage varies according to an applied pressure, and first and second electrodes 341 and 342 respectively provided on both sides of the piezoelectric layer 343. The piezoelectric device 340 may be provided on an upper surface of the resonator 320 and may measure a strain of the resonator 320 by measuring a voltage variation generated in the piezoelectric layer 343 due to a displacement of the resonator 320.

FIG. 9 illustrates a case where a piezoresistive device is used as a sensing device. Referring to FIG. 9, a piezoresistive device 350 may include a piezoresistive layer 353 and first and second electrodes 351 and 352 provided on an upper surface of the piezoresistive layer 353. According to an embodiment, a voltage generated in the piezoresistive layer 353 varies according to an applied pressure. The piezoresistive device 350 may be provided on the upper surface of the resonator 320 and may measure a strain of the resonator 320 by measuring a voltage variation generated in the piezoresistive layer 353 due to a displacement of the resonator 320.

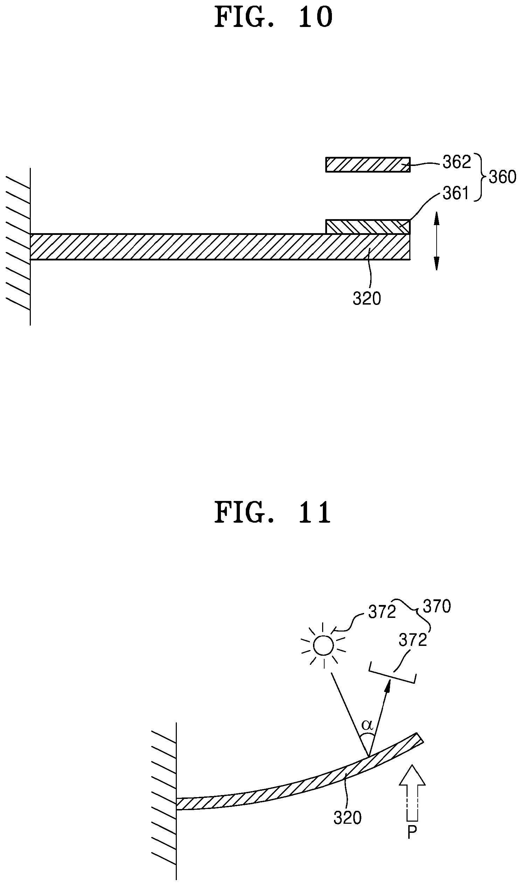

FIG. 10 illustrates a case where a capacitive device is used as a sensing device. Referring to FIG. 10, a capacitive device 360 may include a first conductor 361 provided on an upper surface of one end of the resonator 320, and a second conductor 362 provided over the first conductor 361 to be apart from the first conductor 361. The first conductor 361 is provided to move together with the end of the resonator 320, and the second conductor 362 is fixed. The capacitive device 360 may measure a strain of the resonator 320 by measuring a capacitance variation between the first and second conductors 361 and 362 that is generated due to a displacement of the resonator 320.

FIG. 11 illustrates a case where an optical device is used as a sensing device. Referring to FIG. 11, an optical device 370 may include a light source 371 provided over the resonator 320, and a light receiver 372 that receives light emitted by the light source 371 and reflected by the resonator 320. The optical device 370 may measure a strain of the resonator 320 by measuring a reflection angle ($\alpha$) variation of light that is generated due to a displacement of the resonator 320.

The above-described sensing devices are merely examples, and the other various devices capable of measuring the strain of the resonator 320 may be applied to the strain sensor 390 of FIG. 7.

As such, the resonator 320 manufactured using single crystal silicon having the (100) crystal plane is provided to extend in the <100> crystal orientation. As described above, in the single crystal silicon having the (100) crystal plane, the Young's modulus E is smallest in the <100> crystal orientation, and, even when the Poisson's ratio v is considered, the effective Young's modulus Eeff has a smallest value in the <100> crystal orientation. Accordingly, the resonator 320 according to an exemplary embodiment provided to extend in the <100> crystal orientation has a flexible characteristic that generates a relatively large displacement compared with other crystal orientations.

When the strain sensor 390 is realized using the resonator 320 according to an exemplary embodiment, a high signal output and a high Q-factor may be obtained, and accordingly, measurement sensitivity and frequency band sensitivity with respect to an external input signal may be improved

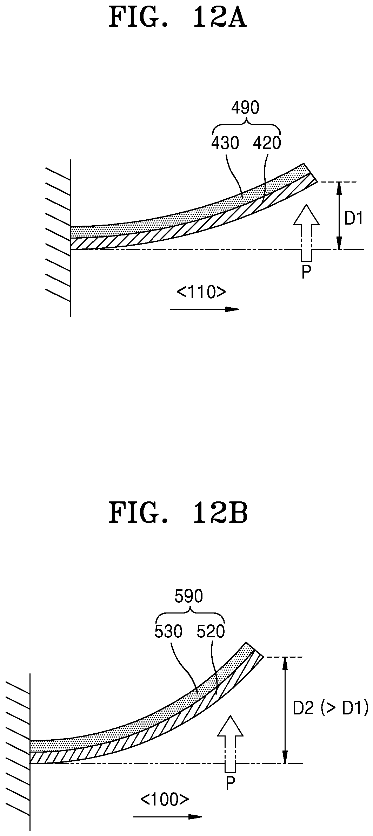

FIG. 12A illustrates a state after an end of a strain sensor 490 using a general resonator 420 is displaced upwards by an external input. The general resonator 420 includes single crystal silicon having the (100) crystal plane, and is provided to extend in the <110> crystal orientation from a support. A sensing device 430, such as a piezoelectric device, is provided on an upper surface of the general resonator 420.

FIG. 12B illustrates a state after an end of a strain sensor 590 using a resonator 520 according to an exemplary embodiment is displaced upwards by an external input. The resonator 520 according to an exemplary embodiment includes single crystal silicon having the (100) crystal plane and is formed to extend in the <100> crystal orientation from a support, and a sensing device 530 is formed on an upper surface of the resonator 520.

An external input P of the same size is applied to the strain sensor 490 of FIG. 12A and the strain sensor 590 of FIG. 12B. In this case, an end of the general resonator 420 of FIG. 12A is displaced by D1, and an end of the resonator 520 according to an exemplary embodiment of FIG. 12B is displaced by D2.

A strain may be expressed as in Equation (2) by using a stress and an effective Young's modulus $E_{eff}$.

$$\varepsilon = \frac{\sigma}{E_{eff}} \quad ..... \text{ Equation (2)}$$

where $\varepsilon$ indicates a strain and $\sigma$ indicates a stress.

According to Equation (2), the strain $\varepsilon$ is proportional to the stress $\sigma$ and is inversely proportional to the effective Young's modulus $E_{eff}$. Accordingly, when the stress $\sigma$ is constant, the strain $\varepsilon$ is inversely proportional to the effective Young's modulus $E_{eff}$.

As described above, in the single crystal silicon having the (100) crystal plane, the effective Young's modulus in the <110> crystal orientation is largest and the effective Young's modulus in the <100> crystal orientation is smallest. Accordingly, when an external input of the same size is applied, the resonator 520 extending in the <100> crystal orientation of FIG. 12B may obtain a relatively large displacement compared with the general resonator 420 extending in the <110> crystal orientation of FIG. 12A.

As such, when the sizes of the external inputs P are the same as each other, the displacement D2 of the resonator 520 extending in the <100> crystal orientation of FIG. 12B is greater than the displacement D1 of the resonator 420 extending in the <110> crystal orientation of FIG. 12A, and thus the strain sensor 590 of FIG. 12B may obtain an improved output signal compared with the strain sensor 490 of FIG. 12A.

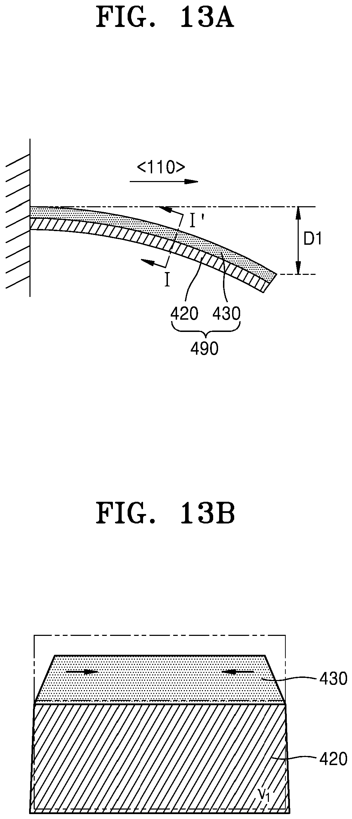

FIG. 13A illustrates a state after an end of the strain sensor 490 using the general resonator 420 is displaced downwards, and FIG. 13B is a cross-sectional view taken along line I-I' of FIG. 13A. In FIG. 13B, a dashed line illustrates a state before the strain sensor 490 is displaced, and $v_1$ indicates the Poisson's ratio of the general resonator 420.

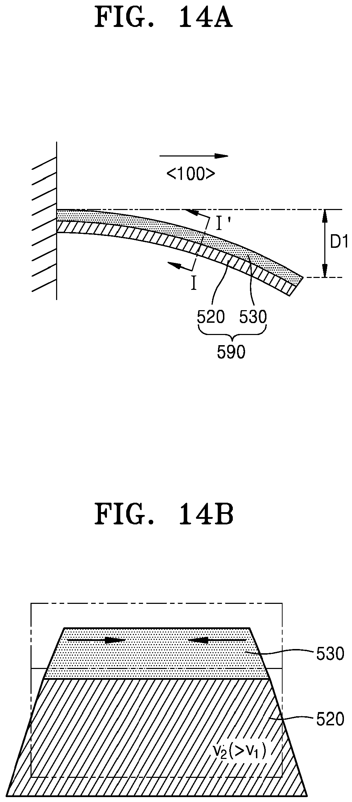

FIG. 14A illustrates a state after an end of the strain sensor 590 using the resonator 520 according to an exemplary embodiment is displaced downwards, and FIG. 13B is a cross-sectional view taken along line I-I' of FIG. 14A. In FIG. 14B, a dashed line illustrates a state before the strain sensor 590 is displaced, and $v_2$ indicates the Poisson's ratio of the resonator 520 according to an exemplary embodiment.

The strain sensor 490 of FIGS. 13A and 13B and the strain sensor 590 of FIGS. 14A and 14B are displaced downwards by the same size D1 by an external input. Referring to FIGS. 13B and 14B, when the general resonator 420 and the resonator 520 according to an exemplary embodiment are displaced downwards, the sensing devices 430 and 530 respectively provided on the general resonator 420 and the resonator 520 according to an exemplary embodiment generate compressive shear strains in a lateral direction. The sizes of arrows illustrated in FIGS. 13B and 14B indicate the sizes of the compressive shear strains generated in the sensing devices 430 and 530.

In the single crystal silicon having the (100) crystal plane, the Poisson's ratio of the <110> crystal orientation is smallest and the Poisson's ratio of the <100> crystal orientation is largest. Thus, the Poisson's ratio $v_2$ of the resonator 520 according to an exemplary embodiment of FIGS. 14A and 14B is greater than the Poisson's ratio $v_1$ of the general resonator 420 of FIGS. 13A and 13B. Accordingly, a larger shear strain may be generated in the sensing device 530 provided on the resonator 520 according to an exemplary embodiment of FIGS. 14A and 14B than in the sensing device 430 provided on the general resonator 420 of FIGS. 13A and 13B, and thus an output signal may improve.

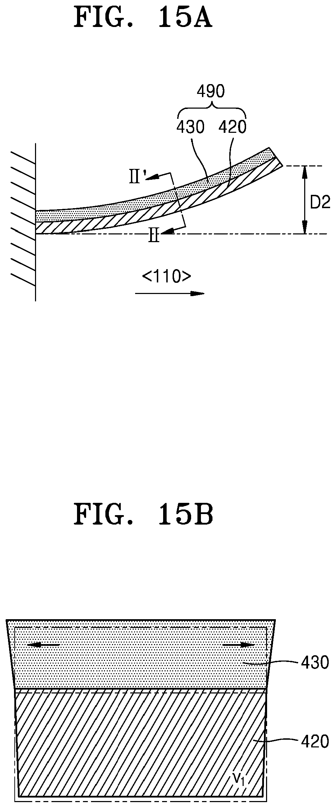

FIG. 15A illustrates a state after an end of the strain sensor 490 using the general resonator 420 is displaced upwards, and FIG. 15B is a cross-sectional view taken along line II-II' of FIG. 15A. In FIG. 15B, a dashed line illustrates a state before the strain sensor 490 is displaced, and $v_1$ indicates the Poisson's ratio of the general resonator 420.

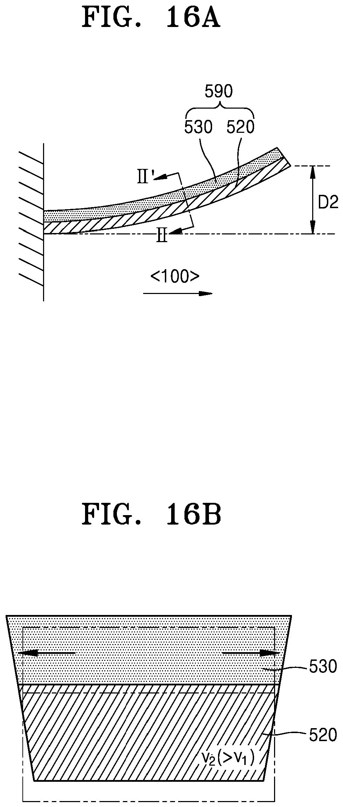

FIG. 16A illustrates a state after an end of the strain sensor 590 using the resonator 520 according to an exemplary embodiment is displaced upwards, and FIG. 16B is a cross-sectional view taken along line II-II' of FIG. 16A. In FIG. 16B, a dashed line illustrates a state before the strain sensor 590 is displaced, and $v_2$ indicates the Poisson's ratio of the resonator 520 according to an exemplary embodiment.

The strain sensor 490 of FIGS. 15A and 15B and the strain sensor 590 of FIGS. 16A and 16B are displaced upwards by the same size D2 by an external input. Referring to FIGS. 15B and 16B, when the general resonator 420 and the resonator 520 according to an exemplary embodiment are displaced upwards, the sensing devices 430 and 530 respectively provided on the general resonator 420 and the resonator 520 according to an exemplary embodiment generate tensile shear strains in the lateral direction. The sizes of arrows illustrated in FIGS. 15B and 16B indicate the sizes of the tensile shear strains generated in the sensing devices 430 and 530.

As described above, because the Poisson's ratio $v_2$ of the resonator 520 according to an exemplary embodiment of FIGS. 16A and 16B is greater than the Poisson's ratio $v_1$ of the general resonator 420 of FIGS. 15A and 15B, a larger shear strain may be generated in the sensing device 530 provided on the resonator 520 according to an exemplary embodiment of FIGS. 16A and 16B than in the sensing device 430 provided on the general resonator 420 of FIGS. 15A and 15B, and thus an output signal may improve.

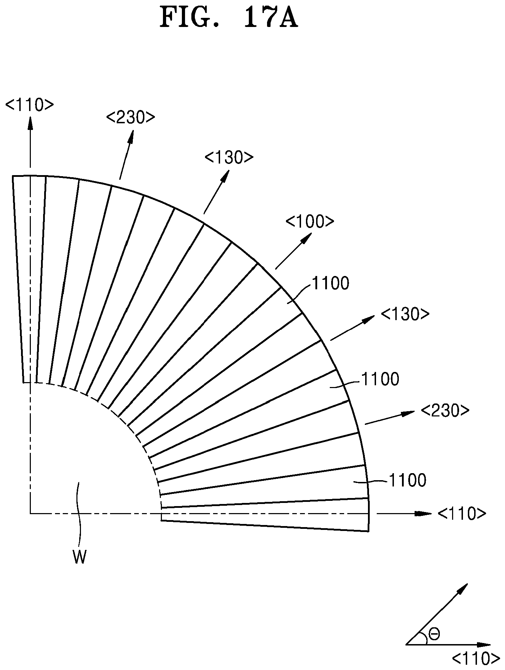

FIG. 17A illustrates resonators 1100 manufactured by patterning the single crystal silicon wafer W having the (100) crystal plane in a crystal orientation.

Referring to FIG. 17A, sixteen resonators 1100 manufactured by patterning the single crystal silicon wafer W having the (100) crystal plane in different crystal orientations are arranged radially.

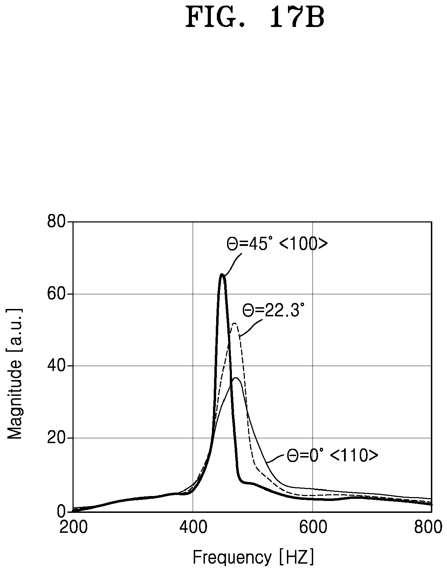

FIG. 17B illustrates resonance characteristics according to the crystal orientations of the resonators 1100 of FIG. 17A. FIG. 17B illustrates a result obtained by measuring displacements according to frequencies when the same external input has been applied to three of the resonators 1100 of FIG. 17A, namely, to a resonator 1100 patterned in the <110> crystal orientation being a direction of the flat zone FZ, a resonator 1100 patterned in the <100> crystal orientation 45° inclined with respect to the <110> crystal orientation, and a resonator 1100 patterned in a crystal orientation between the <110> crystal orientation and the <100> crystal orientation (in detail, a crystal orientation 22.3° inclined with respect to the <110> crystal orientation).

Referring to FIG. 17B, the resonator 1100 patterned in the <100> crystal orientation from among the three resonators 1100 has a largest displacement and a smallest resonance frequency bandwidth, and the resonator 1100 patterned in the <110> crystal orientation has a smallest displacement and a largest resonance frequency bandwidth. A displacement and a resonance frequency bandwidth of the resonator 1100 patterned in the crystal orientation between the <110> crystal orientation and the <100> crystal orientation have values between the resonator 1100 patterned in the <100> crystal orientation and the resonator 1100 patterned in the <110> crystal orientation.

As such, as the resonator 1100 patterned in the <100> crystal orientation 45° inclined with respect to the <110> crystal orientation being the direction of the flat zone FZ has a largest displacement, the resonator 1100 has a highest output, and, as the resonator 1100 patterned in the <100> crystal orientation 45° inclined with respect to the <110> crystal orientation being the direction of the flat zone FZ has a smallest resonance frequency bandwidth, the resonator 1100 has a highest frequency selectivity and a highest Q-factor. Accordingly, when a sensor is manufactured using the resonator 1100 patterned in the <100> crystal orientation, high efficiency may be obtained.

A case where a resonator extending in the <100> crystal orientation is realized using both the Young's modulus and the Poisson's ratio of the single crystal silicon having the (100) crystal plane has been described above. However, embodiments are not limited thereto, and a crystal orientation using only one of the Young's modulus and the Poisson's ratio may be defined as a direction in which a resonator extends. For example, a crystal orientation having a smallest Young's modulus or a crystal orientation having a largest Poisson's ratio may be defined as a direction in which a resonator extends.

A resonator according to the above-described exemplary embodiment is applicable to, for example, oscillation sensors such as mechanical filters and acoustic sensors.

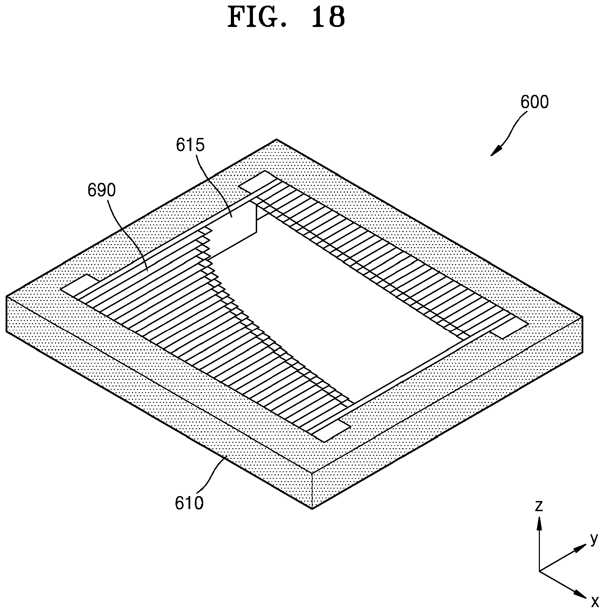

FIG. 18 illustrates a microphone 600 according to another exemplary embodiment. The microphone 600 of FIG. 18 is a microphone which is a type of an acoustic sensor manufactured using a resonator according to the above-described exemplary embodiment.

Referring to FIG. 18, the microphone 600 includes a substrate 610 in which a cavity 615 is formed, and a sensor array 690 provided on the cavity 615 of the substrate 610. The sensor array 690 includes a plurality of resonators, and a plurality of sensing devices that measure strains of the resonators.

The plurality of resonators have different resonance frequencies to sense acoustic frequencies of different bands. To this end, the plurality of resonators are provided to have different dimensions. For example, the plurality of resonators may be provided to have different lengths, widths, or thicknesses. The number of resonators provided on the cavity 615 may be modified variously according to design conditions.

FIG. 18 illustrates a case where resonators having different lengths are arranged in two rows along the edges of both sides of the cavity 615 and are parallel to each other. However, this is only an example, and resonators may be arranged in various other forms. For example, the resonators may be arranged in one row.

The resonators are provided to each extend in a lengthwise direction from a support of the substrate 610. As described above, the plurality of resonators include single crystal silicon having the (100) crystal plane, and are provided to each extend in the <100> crystal orientation of the single crystal silicon.

The microphone 600 of FIG. 18 may have directionality as an acoustic input part, resonators, and an acoustic output part are arranged in one direction. In detail, the microphone 600 may have bi-directionality, for example, directionality in a +z-axis direction and directionality in a -z-axis direction.

In the microphone 600 of FIG. 18, the resonators that constitute the sensor array 690 include single crystal silicon having the (100) crystal plane and are provided to each extend in the <100> crystal orientation from the support of the substrate 610, and thus an improved output and improved sensitivity may be obtained. Moreover, because the resonators have narrow resonance frequency bands, frequency selectivity and a Q-factor may improve, and accordingly, a high resolution may be realized.

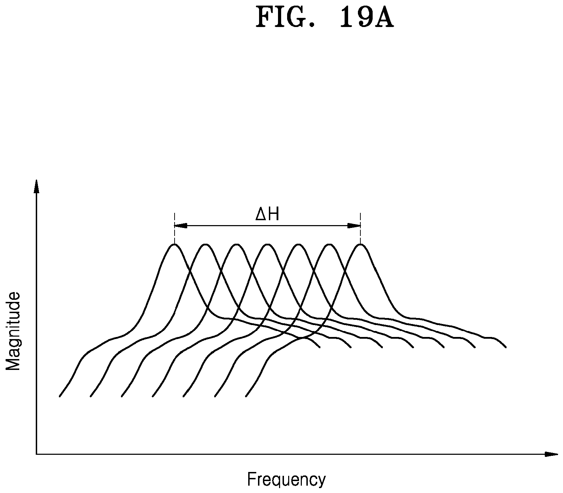

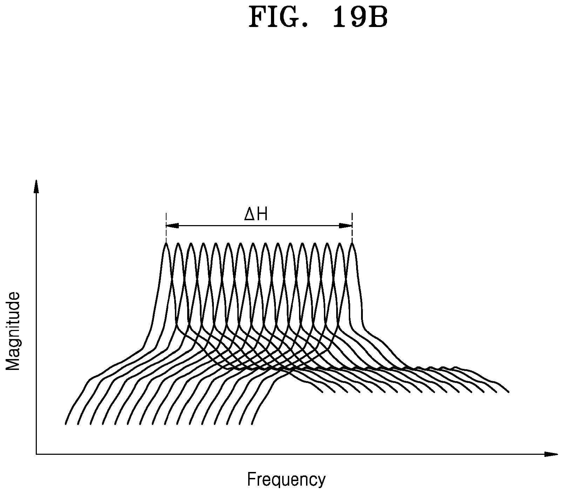

FIG. 19A illustrates resonance characteristics of a microphone using general resonators. The general resonators include single crystal silicon having the (100) crystal plane and each extend in the <110> crystal orientation. FIG. 19B illustrates resonance characteristics of a microphone using resonators according to an exemplary embodiment. The resonators according to an exemplary embodiment include single crystal silicon having the (100) crystal plane and each extend in the <100> crystal orientation.

Referring to FIGS. 19A and 19B, the resonators according to an exemplary embodiment each extending in the <100> crystal orientation have narrower resonance frequency bands than the general resonators each extending in the <110> crystal orientation. Accordingly, more resonators each extending in the <100> crystal orientation may be arranged within the same input frequency range ΔH than resonators each extending in the <110> crystal orientation, and thus a higher resolution may be realized.

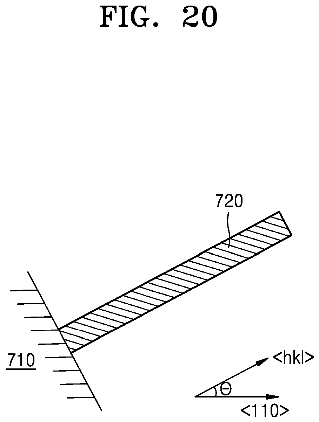

FIG. 20 illustrates a resonator 720 according to another exemplary embodiment.

Referring to FIG. 20, the resonator 720 includes single crystal silicon having the (100) crystal plane, and is provided to extend in an <hkl> crystal orientation from a support 710. The <hkl> crystal orientation may be a crystal orientation between the <110> crystal orientation and the <100> crystal orientation. In other words, the <hkl> crystal orientation may be a direction inclined at an angle between 0° and 45° with respect to the <110> crystal orientation being the direction of the flat zone FZ.

As described above, a displacement and a resonance frequency bandwidth of the resonator 720 extending in the crystal orientation between the <110> crystal orientation and the <100> crystal orientation have values between the general resonator 220 patterned in the <110> crystal orientation and the resonator 320 according to an exemplary embodiment patterned in the <100> crystal orientation.

A direction in which the resonator 720 of FIG. 20 extends may vary according to requirements in application fields. For example, the resonator 720 extending in an arbitrary crystal orientation between the <110> crystal orientation and the <100> crystal orientation may be manufactured to satisfy a Young's modulus and/or a Poisson's ratio necessary for desired resonance characteristics.

A case where a resonator is manufactured using single crystal silicon having the (100) crystal plane has been described above. However, embodiments are not limited thereto, and a resonator may be manufactured using single crystal silicon having a crystal plane other than the (100) crystal plane.

Alternatively, a resonator may be manufactured using a single crystal material other than single crystal silicon. In this case, the resonator may be provided to extend from a support in a crystal orientation that satisfies at least one from among the Young's modulus and the Poisson's ratio from among crystal orientations of the single crystal material. For example, the resonator may be provided to extend in a crystal orientation having a smallest Young's modulus or in a crystal orientation having a largest Poisson's ratio. However, embodiments are not limited thereto.

According to the above-described embodiments, a resonator may be manufactured using a Young's modulus and a Poisson's ratio that vary according to crystal orientations of a single crystal material, and thus a sensor that satisfies desired resonance characteristics may be realized. When a resonator is manufactured using a single crystal silicon wafer having the (100) crystal plane, the single crystal silicon wafer is patterned to extend in the <100> crystal orientation, thereby realizing a resonator capable of obtaining a high output. In addition, because the resonator has a narrow resonance frequency band, frequency selectivity and a Q-factor may improve. Therefore, a sensor having high sensitivity and a high resolution may be realized when using the resonator. While one or more embodiments have been described with reference to the figures, it will be understood by those of ordinary skill in the art that various changes in form and details may be made therein without departing from the scope as defined by the following claims.

**Claims**

**1.** A sensor array (600) comprising:

a plurality of resonators (690) which are patterned from a substrate comprising a single crystal silicon wafer having a (100) crystal plane, wherein each of the plurality of resonators extending in a lengthwise direction from a support and having different resonance frequencies and different dimensions; and
a plurality of sensing devices configured to measure strains of the plurality of resonators; and
wherein each resonator extends in a lengthwise direction from a support and comprises:

a single crystal material, wherein the single crystal material comprises a single crystal silicon,
wherein the resonator extends in a crystal orientation, the crystal orientation being from among a plurality of crystal orientations of the single crystal material, wherein the resonator extends in a <100> crystal orientation of the single crystal silicon such that the resonator extends in the crystal orientation having the smallest Young's modulus and the largest Poisson's ratio for said single crystal silicon.

**2.** The sensor array (600) of claim 1, wherein each resonator (690) has a beam shape extending in the lengthwise direction.

**3.** The sensor array (600) of any preceding claim, wherein at least one end of each resonator (690) is fixed to the support.

**4.** The sensor array (600) of any preceding claim, wherein the support comprises the single crystal material.

**5.** The sensor array (600) of any preceding claim, wherein the plurality of sensing devices comprises a piezoelectric device, a piezoresistive device, or a capacitive device.

**6.** The sensor array (600) of any preceding claim, wherein the plurality of sensing devices comprises an optical device that measures an angle variation of light that is reflected by the resonator.

**7.** A method of manufacturing a sensor array comprising;

manufacturing a plurality of resonators, wherein each of the plurality of resonators extending in a lengthwise direction from a support and having different resonance frequencies and different dimensions; and
coupling each resonator to a sensing device configured to measure strains of a resonator, and

wherein manufacturing each resonator comprises:

patterning a substrate including a single crystal material to form a portion of the substrate to extend in a crystal orientation having a smallest Young's modulus or a largest Poisson's ratio, the crystal orientation being from among crystal orientations of the single crystal material, wherein the substrate includes single crystal silicon having a (100) crystal plane, and the patterning the substrate further comprises: patterning the substrate to extend the portion of the substrate in a <100> crystal orientation of the single crystal silicon.

**Patentansprüche**

1. Sensoranordnung (600), umfassend:

eine Vielzahl von Resonatoren (690), die aus einem Substrat strukturiert ist, das einen Einkristallsiliziumwafer mit einer (100)-Kristallebene umfasst, wobei sich jeder aus der Vielzahl von Resonatoren in einer Längsrichtung von einem Träger erstreckt und unterschiedliche Resonanzfrequenzen und unterschiedliche Abmessungen aufweist; und eine Vielzahl von Erfassungsvorrichtungen, die konfiguriert ist, um Dehnungen der Vielzahl von Resonatoren zu messen; und wobei sich jeder Resonator in einer Längsrichtung von einem Träger erstreckt und Folgendes umfasst:

ein Einkristallmaterial, wobei das Einkristallmaterial ein Einkristallsilizium umfasst, wobei sich der Resonator in einer Kristallausrichtung erstreckt, wobei die Kristallausrichtung aus einer Vielzahl von Kristallausrichtungen des Einkristallmaterials ist, wobei sich der Resonator in einer <100>-Kristallausrichtung des Einkristallsiliziums erstreckt, sodass sich der Resonator in der Kristallausrichtung mit dem kleinsten Elastizitätsmodul und dem größten Poisson-Verhältnis für das Einkristallsilizium erstreckt.

2. Sensoranordnung (600) nach Anspruch 1, wobei jeder Resonator (690) eine Strahlform aufweist, die sich in der Längsrichtung erstreckt.

3. Sensoranordnung (600) nach einem vorhergehenden Anspruch, wobei zumindest ein Ende jedes Resonators (690) an dem Träger befestigt ist.

4. Sensoranordnung (600) nach einem vorhergehenden Anspruch, wobei der Träger das Einkristallmaterial umfasst.

5. Sensoranordnung (600) nach einem vorhergehenden Anspruch, wobei die Vielzahl von Erfassungsvorrichtungen eine piezoelektrische Vorrichtung, eine piezoresistive Vorrichtung oder eine kapazitive Vorrichtung umfasst.

6. Sensoranordnung (600) nach einem vorhergehenden Anspruch, wobei die Vielzahl von Erfassungsvorrichtungen eine optische Vorrichtung umfasst, die eine Winkelvariation von Licht misst, das durch den Resonator reflektiert wird.

7. Verfahren zur Herstellung einer Sensoranordnung, umfassend;

Herstellen einer Vielzahl von Resonatoren, wobei sich jeder aus der Vielzahl von Resonatoren in einer Längsrichtung von einem Träger erstreckt und unterschiedliche Resonanzfrequenzen und unterschiedliche Abmessungen aufweist; und Koppeln jedes Resonators an eine Erfassungsvorrichtung, die konfiguriert ist, um Dehnungen eines Resonators zu messen, und wobei das Herstellen jedes Resonators Folgendes umfasst:

Strukturieren eines Substrats, das ein Einkristallmaterial beinhaltet, um einen Teil des Substrats zu bilden, sodass er sich in einer Kristallausrichtung mit einem kleinsten Elastizitätsmodul oder einem größten Poisson-Verhältnis erstreckt, wobei die Kristallausrichtung aus Kristallausrichtungen des Einkristallmaterials ist, wobei das Substrat Einkristallsilizium mit einer (100)-Kristallebene beinhaltet, und das Strukturieren des Substrats ferner Folgendes umfasst: Strukturieren des Substrats, sodass sich der Teil des Substrats in einer <100>-Kristallausrichtung des Einkristallsiliziums erstreckt.

**Revendications**

1. Réseau de capteurs (600) comprenant :

une pluralité de résonateurs (690) qui sont structurés à partir d'un substrat comprenant une tranche de silicium monocristallin comportant un plan cristallin (100), chacun de la pluralité de résonateurs s'étendant dans une direction de la longueur à partir d'un support et comportant des fréquences de résonance différentes et des dimensions différentes ; et

une pluralité de dispositifs de détection configurés pour mesurer les contraintes de la pluralité de résonateurs ; et

chaque résonateur s'étendant dans une direction de la longueur à partir d'un support et comprenant :

un matériau monocristallin, ledit matériau monocristallin comprenant du silicium monocristallin,

ledit résonateur s'étendant dans une orientation cristalline, l'orientation cristalline étant parmi une pluralité d'orientations cristallines du matériau monocristallin, ledit résonateur s'étendant dans une orientation cristalline <100> du silicium monocristallin de sorte que le résonateur s'étende dans l'orientation cristalline comportant le plus petit module d'Young et le plus grand coefficient de Poisson pour ledit silicium monocristallin.

2. Réseau de capteurs (600) selon la revendication 1, chaque résonateur (690) comportant une forme de faisceau s'étendant dans la direction de la longueur.

3. Réseau de capteurs (600) selon une quelconque revendication précédente, au moins une extrémité de chaque résonateur (690) étant fixée au support.

4. Réseau de capteurs (600) selon une quelconque revendication précédente, ledit support comprenant le matériau monocristallin.

5. Réseau de capteurs (600) selon une quelconque revendication précédente, ladite pluralité de dispositifs de détection comprenant un dispositif piézoélectrique, un dispositif piézorésistif ou un dispositif capacitif.

6. Réseau de capteurs (600) selon une quelconque revendication précédente, ladite pluralité de dispositifs de détection comprenant un dispositif optique qui mesure une variation angulaire de la lumière qui est réfléchie par le résonateur.

7. Procédé de fabrication d'un réseau de capteurs comprenant ;

la fabrication d'une pluralité de résonateurs, chacun de la pluralité de résonateurs s'étendant dans une direction de la longueur à partir d'un support et comportant différentes fréquences de résonance et différentes dimensions ; et
le couplage de chaque résonateur à un dispositif de détection configuré pour mesurer les contraintes d'un résonateur, et

ladite fabrication de chaque résonateur comprenant :

la structuration d'un substrat comprenant un matériau monocristallin pour former une partie du substrat afin qu'il s'étende dans une orientation cristalline comportant le plus petit module d'Young ou le plus grand coefficient de Poisson, l'orientation cristalline étant parmi les orientations cristallines du matériau monocristallin,

ledit substrat comprenant du silicium monocristallin comportant un plan cristallin (100), et

ladite structuration du substrat comprenant en outre : la structuration du substrat pour étendre la partie du substrat dans une orientation cristalline <100> du silicium monocristallin.

# FIG. 1A

# FIG. 1B

# FIG. 2

# FIG. 3A

# FIG. 3B

# FIG. 4

# FIG. 5

# FIG. 6A

320

<110>

<100>

310

<110>

# FIG. 6B

310

320

<100>

# FIG. 7

# FIG. 8

# FIG. 9

# FIG. 10

# FIG. 11

# FIG. 12A

# FIG. 12B

# FIG. 13A

<110>

I'

I

D1

420 430

490

# FIG. 13B

430

420

V1

# FIG. 14A

<100>

D1

I'

I

520  530

590

# FIG. 14B

530

520

$v_2(>v_1)$

# FIG. 15A

490
{
430   420
}

II'

490

D2

II

<110>

# FIG. 15B

430

420

V1

# FIG. 16A

# FIG. 16B

# FIG. 17A

FIG. 17B

# FIG. 18

# FIG. 19A

# FIG. 19B

FIG. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2017119351 A1
- US 2017143308 A1
- US 2017119350 A1
- US 20110266919 A1
- US 9090451 B1

### Non-patent literature cited in the description

- What is the Young's Modulus of Silicon?. **HOPCROFT M A et al.** JOURNAL OF MICROELEC-TROMECHANICAL SYSTEMS. IEEE SERVICE CENTER, 01 April 2010, vol. 19, 229-238